**Europäisches Patentamt**

**European Patent Office**

**Office européen des brevets**

(19)

(11) Veröffentlichungsnummer: **0 192 990**
**B1**

(12)

# EUROPÄISCHE PATENTSCHRIFT

(45) Veröffentlichungstag der Patentschrift:
**12.09.90**

(51) Int. Cl.⁵: **H05K 7/14, A47B 88/00**

(21) Anmeldenummer: **86101256.5**

(22) Anmeldetag: **31.01.86**

(54) **Vorrichtung zum seitlichen Führen eines in ein Gestell oder einen Schaltschrank einschiebbaren Baugruppenträgers.**

(30) Priorität: **26.02.85 DE 3506636**

(43) Veröffentlichungstag der Anmeldung:
**03.09.86 Patentblatt 86/36**

(45) Bekanntmachung des Hinweises auf die Patenterteilung:
**12.09.90 Patentblatt 90/37**

(84) Benannte Vertragsstaaten:
**AT BE CH FR GB IT LI LU NL SE**

(56) Entgegenhaltungen:
**EP-A- 0 092 104**
**EP-A- 0 107 525**
**US-A- 2 809 085**
**US-A- 3 146 048**
**US-A- 3 904 254**

(73) Patentinhaber: **Rittal-Werk Rudolf Loh GmbH & Co. KG,**
**Auf dem Stützelberg, D-6348 Herborn(DE)**

(72) Erfinder: **Bernhard, Jürgen, Minzeborn 5,**
**D-6342 Haiger 9(DE)**
Erfinder: **Bovermann, Klaus-Dieter, Am Oberg 7,**
**D-3565 Niederdieten(DE)**
Erfinder: **Erlam, David, 5, Braeside Close Olivers**
**Battery, Winchester, Hants(GB)**

(74) Vertreter: **Vogel, Georg,**
**Hermann-Essig-Strasse 35 Postfach 105,**
**D-7141 Schwieberdingen(DE)**

ACTORUM AG

## Beschreibung

Die Erfindung betrifft eine Vorrichtung zum seitlichen Führen eines in ein Gestell oder einen Schaltschrank einschiebbaren Baugruppenträgers, die aus einer mit dem Gestell oder dem Schaltschrank horizontal verbindbaren Trägerschiene, einem auf der Trägerschiene bzw. auf einer in der Trägerschiene verstellbaren Kugelführung axial verschiebbaren Schieber und einem an dem Schieber festlegbaren und mit einem Seitenteil des Baugruppenträgers verbindbaren, an der Rückseite desselben vorstehenden Ausleger besteht, wobei der Ausleger in Schrägstellung zur Trägerschiene in den Schieber einführbar und durch Absenken in die horizontale Verbindungsstellung axial unverschiebbar an diesem festlegbar ist.

Eine Vorrichtung dieser Art ist z.B. aus der EP-A 0 092 104 bekannt. Diese bekannte Vorrichtung hat den Vorteil, daß die einfachen Teile leicht montierbar sind und daß der Baugruppenträger als Ganzes auf einfache Art aus dem Gestell oder dem Schaltschrank herausgenommen und wieder eingesetzt werden kann.

Es hat sich gezeigt, daß bei dieser bekannten Vorrichtung das Wiedereinsetzen des Baugruppenträgers schwierig ist, da sich der Schieber beim Einführen des Auslegers des Baugruppenträgers auf der Trägerschiene verschieben kann.

Es ist Aufgabe der Erfindung, eine Vorrichtung der eingangs erwähnten Art so zu verbessern, daß der Schieber beim Herausnehmen des Baugruppenträgers automatisch auf der Trägerschiene unverschiebbar arretiert und beim Einführen und Festlegen des Auslegers des Baugruppenträgers am Schieber wieder automatisch entriegelt wird.

Diese Aufgabe wird nach der Erfindung dadurch gelöst, daß an dem Schieber ein mittels Feder belastetes Verriegelungselement angebracht ist, das bei schrägstehendem bzw. vom Schieber abgenommenem Ausleger aufgrund der Federkraft mit einem Verriegelungsansatz in eine Verriegelungsaufnahme der Trägerschiene eingreift und den Schieber axial unverschiebbar an der Trägerschiene festhält, und daß der am Schieber angebrachte und in die horizontale Verbindungsstellung gebrachte Ausleger das Verriegelungselement entgegen der Federkraft so verstellt, daß der Verriegelungsansatz aus der Verriegelungsaufnahme bewegt und der Schieber mit dem daran festgelegten Ausleger auf der Trägerschiene axial verstellbar sind.

Dabei ist das Verriegelungselement vorzugsweise als Verriegelungshebel ausgebildet, der drehbar am Schieber gelagert und mittels der Feder in Richtung der Verriegelungsstellung gehalten ist.

Der Verriegelungshebel wird beim Schrägstellen des Auslegers, so wie es beim Herausnehmen des Baugruppenträgers der Fall ist, durch die Feder automatisch in die Verriegelungsstellung gebracht. Der Schieber ist auf der Trägerschiene unverschiebbar festgehalten, was das Einführen des Auslegers in den Schieber wesentlich erleichtert, da dieser dabei auf der Trägerschiene nicht ausweichen kann. Wird der eingeführte Ausleger in die horizontale Verbindungsstellung abgesenkt, wird automatisch die Verriegelung des Schiebers aufgehoben und der Baugruppenträger kann in das Gestell, den Schaltschrank und dgl. eingeschoben werden.

Eine bevorzugte Ausgestaltung ist dadurch gekennzeichnet, daß der Schieber der Einführseite abgekehrt mit einer horizontal gerichteten Stecklasche und der Einführseite zugekehrt mit einer vertikalen, nach oben offenen Stecklasche versehen ist, daß der Ausleger an seinem freien Ende mit einem horizontal gerichteten Einsteckschlitz und dem Baugruppenträger zugekehrt mit einem vertikalen, nach unten offenen Einführschlitz versehen ist, daß im Bereich der Unterkante des Schiebers der Verriegelungshebel so gelagert ist, daß er außerhalb der Trägerschiene liegt und von der Unterseite der Trägerschiene her in die in den unteren Seitenschenkel eingebrachte Verriegelungsaufnahme einrastet und daß der Verriegelungshebel mit einem seitlich abstehenden Ansatz versehen ist, auf dem sich unter entsprechender Auslenkung des Verriegelungshebels die Unterkante des eingeführten Auslegers abstützt. Auf diese Weise wird durch den Verriegelungshebel das Einführen des Auslegers, das von oben her erfolgt, in den Schieber nicht behindert oder beeinträchtigt.

Damit der Verriegelungshebel als einfaches Stanzteil ausgebildet sein kann, sieht eine Weiterbildung vor, daß der Verriegelungshebel mittels eines Lagerbolzens in einem taschenförmigen Teil des Schiebers gelagert ist, das um mindestens die Dicke des Verriegelungshebels von der Trägerschiene abgesetzt ist.

Die Abfederung des Verriegelungshebels wird nach einer Ausgestaltung dadurch erreicht, daß der Lagerbolzen horizontal und senkrecht zur Längsachse der Trägerschiene und des Auslegers ausgerichtet ist und daß eine als Zugfeder ausgebildete V- bzw. U-förmige Drahtfeder den Verriegelungshebel gegen die Trägerschiene zieht, wobei ein Ende der Drahtfeder im Bereich der Oberkante des Schiebers und das andere Ende der Drahtfeder an dem Ansatz des Schiebers eingehängt sind.

Die Erfindung wird anhand eines in der Zeichnung dargestellten Ausführungsbeispiels näher erläutert. Es zeigt:

Fig. 1 eine Trägerschiene mit eingeführtem und arretiertem Schieber, auf die der Befestigungsseite abgekehrte Seite gesehen,

Fig. 2 die Trägerschiene nach Fig. 1 mit schräg stehendem Ausleger in der Einführstellung und

Fig. 3 die Trägerschiene mit verschiebbarem und mit dem Ausleger verbundenem Schieber.

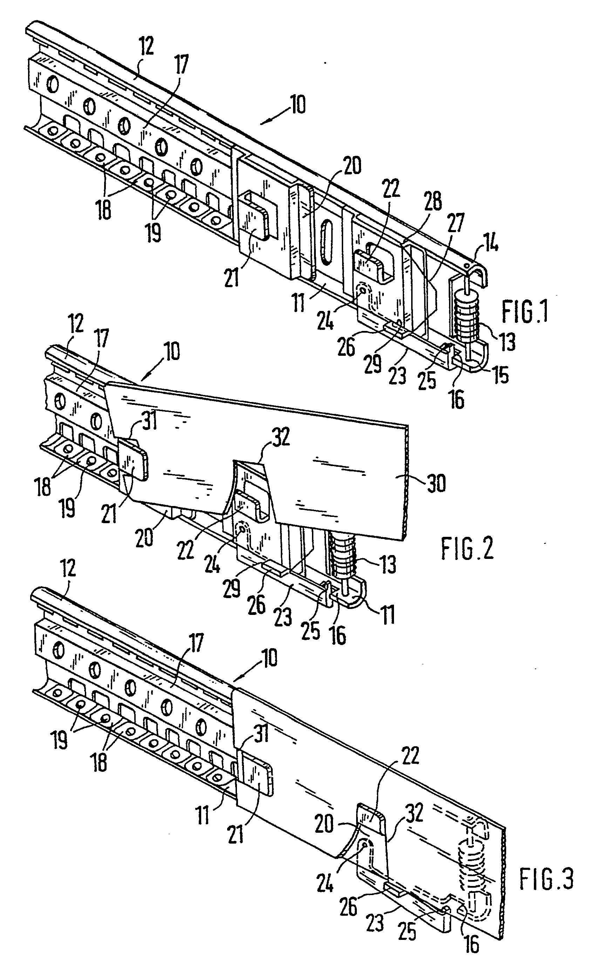

Die bei dem Ausführungsbeispiel verwendete Trägerschiene 10 wird mit der in der Fig. 1 nicht einsehbaren Befestigungsseite an dem Gestell, dem Schaltschrank und dgl. befestigt, z.B. angeschraubt. Auf der einsehbaren Führungsseite ist die Trägerschiene 10 durch die beiden Seitenschenkel 11 und 12 U-förmig gestaltet. Da diese Seitenschenkel 11 und 12 gewölbt sind, bilden sie Hinterschnitte und damit eine Führungsaufnahme für den Schieber 20 oder die U-förmige Kugelführung 17. Der Schieber 20 ragt mit zwei taschenförmigen Teilen aus der Führungsaufnahme der Trägerschiene 10.

Das dem Baugruppenträger zugekehrte vordere Ende der Trägerschiene 10 trägt die in den Bohrungen 14 und 15 der Seitenschenkel 11 und 12 drehbar gelagerte Rolle 13, die zur Verbesserung der Führung des mit dem Schieber 20 verbindbaren Auslegers 30 dient. An dem der Einführseite abgekehrten Ende trägt der Schieber 20 die ausgestanzte und ausgebogene, horizontal gerichtete Stecklasche 21, während der Einführseite zugekehrt, die ausgestanzte und ausgebogene Stecklasche 22 vertikal gerichtet und nach oben offen ist.

Im Bereich der Unterkante des Schiebers 20 ist an dem vorderen Taschenteil als Verriegelungselement der Verriegelungshebel 23 drehbar gelagert. Der Lagerbolzen 24 ist horizontal ausgerichtet und steht senkrecht zur Längsrichtung der Trägerschiene 10. Da das Taschenteil des Schiebers 20 um mindestens die Dicke des Verriegelungshebels 23 von der Trägerschiene 10 abgesetzt ist, kann dieser mit dem eingewinkelten Verriegelungsansatz 25 von unten her in die im unteren Seitenschenkel 11 der Trägerschiene 10 eingebrachte Verriegelungsaufnahme 16 eingreifen. Die U- bzw. V-förmige Drahtfeder 27 hält den Verriegelungshebel 23 in der in Fig. 1 gezeigten Verriegelungsstellung. Dabei sind das eine Ende 28 der Drahtfeder 27 an der Oberkante des Schiebers 20 und das untere Ende 29 der Drahtfeder 27 an dem seitlich am Schieber 20 abstehenden Ansatz 26 eingehängt. Die Drahtfeder 27 ist als Zugfeder ausgelegt.

Wird der Baugruppenträger in das Gestell, den Schaltschrank und dgl. eingeschoben, dann werden die an der Rückseite des Baugruppenträgers vorstehenden Ausleger 30 wieder an den Schiebern 30 festgelegt. Dazu wird, wie Fig. 2 zeigt, der Baugruppenträger schräg gehalten, so daß der Ausleger 30 mit dem stirnseitigen Einsteckschlitz 31 in die Stecklasche 21 eingeführt werden kann. Wird der Baugruppenträger dann abgesenkt, greift die Stecklasche 22 in den Einführschlitz 32 ein, der so bemessen ist, daß der Ausleger 30 und damit der daran befestigte Baugruppenträger seine horizontale Verbindungsstellung einnimmt.

Wie Fig. 3 zeigt, nimmt dabei die Unterkante des Auslegers 30 über den seitlich abstehenden Ansatz 26 den Verriegelungshebel 23 so weit mit, daß der Verriegelungsansatz 25 aus der Verriegelungsaufnahme 16 herausgeführt ist. Der Schieber 20 kann mit dem daran festgelegten Ausleger 30 wieder axial auf der Trägerschiene 10 oder der Kugelführung 17 verstellt werden. Dies hängt davon ab, ob der Schieber 20 selbst auf der Trägerschiene 10 oder auf der in der Trägerschiene 10 verstellbaren Kugelführung 17 verstellbar ist.

Wie Fig. 2 zeigt, bleibt während des schrägen Einführens des Auslegers 30 in die Stecklasche 21 der Schieber 20 an der Trägerschiene 10 arretiert. Die Arretierung wird erst zum Schluß der Absenkbewegung des Auslegers 30 aufgehoben. Dabei ist aber die Stecklasche 22 schon weit genug in den Einführschlitz 32 eingeführt, um den Ausleger 30 am Schieber 20 festzulegen. Da der Ansatz 26 am Schieber 20 näher am Drehpunkt des Verriegelungshebels 23 sitzt, macht der Verriegelungsansatz 25 am Ende des Verriegelungshebels 23 einen entsprechend größeren Verstellweg. Zur Entriegelung genügt daher schon ein kleiner Verstellweg des Ansatzes 26, d.h. ein kleiner Schwenkwinkel des Verriegelungshebels 23.

Es ist einleuchtend, daß das federbelastete Verriegelungselement auch anders gestaltet werden kann. Es ist nur darauf zu achten, daß die Feder das Verriegelungselement beim Abnehmen des Auslegers vom Schieber automatisch die Verriegelungsstellung herstellt und daß durch den wieder am Schieber festgelegten Ausleger diese Verriegelungsstellung automatisch wieder aufgehoben wird.

## Patentansprüche

1. Vorrichtung zum seitlichen Führen eines in ein Gestell oder einen Schaltschrank einschiebbaren Baugruppenträgers, die aus einer mit dem Gestell oder dem Schaltschrank horizontal verbindbaren Trägerschiene, einem auf der Trägerschiene bzw. auf einer in der Trägerschiene verstellbaren Kugelführung axial verschiebbaren Schieber und einem an dem Schieber festlegbaren und mit einem Seitenteil des Baugruppenträgers verbindbaren, an der Rückseite desselben vorstehenden Ausleger besteht, wobei der Ausleger in Schrägstellung zur Trägerschiene in den Schieber einführbar und durch Absenken in die horizontale Verbindungsstellung axial unverschiebbar an diesem festlegbar ist, dadurch gekennzeichnet, daß an dem Schieber (20) ein mittels Feder (27) belastetes Verriegelungselement angebracht ist, das bei schrägstehendem bzw. vom Schieber (20) abgenommenem Ausleger (30) aufgrund der Federkraft mit einem Verriegelungsansatz (25) in eine Verriegelungsaufnahme (16) der Trägerschiene (10) eingreift und den Schieber (20) axial unverschiebbar an der Trägerschiene (10) festhält, und daß der am Schieber (20) angebrachte und in die horizontale Verbindungsstellung gebrachte Ausleger (30) das Verriegelungselement entgegen der Federkraft so verstellt, daß der Verriegelungsansatz (25) aus der Verriegelungsaufnahme (16) bewegt und der Schieber (20) mit dem daran festgelegten Ausleger (30) auf der Trägerschiene (10) axial verstellbar sind.

2. Vorrichtung nach Anspruch 1, dadurch gekennzeichnet, daß das Verriegelungselement als Verriegelungshebel (23) ausgebildet ist, der an dem Schieber (20) drehbar gelagert und mittels der Feder (27) in Richtung der Verriegelungsstellung gehalten ist.

3. Vorrichtung nach Anspruch 2, dadurch gekennzeichnet, daß der Schieber (20) der Einführseite abgekehrt mit einer horizontal gerichteten Stecklasche (21) und der Einführseite zugekehrt mit einer vertikalen, nach oben offenen Stecklasche (22) versehen ist, daß der Ausleger (30) an seinem freien Ende it einem horizontal gerichteten Einsteckschlitz (31) und dem Baugruppenträger zugekehrt mit einem vertikalen, nach unten offenen Einführschlitz (32) versehen ist,

daß im Bereich der Unterkante des Schiebers (20) der Verriegelungshebel (23) so gelagert ist, daß er außerhalb der Trägerschiene (10) liegt und von der Unterseite der Trägerschiene (10) her in die in den unteren Seitenschenkel (11) derselben eingebrachte Verriegelungsaufnahme (16) einrastet und

daß der Verriegelungshebel .(23). mit einem seitlich abstehenden Ansatz (26) versehen ist, auf dem sich unter entsprechender Auslenkung des Verriegelungshebels die Unterkante des eingeführten Auslegers (30) abstützt.

4. Vorrichtung nach einem der Ansprüche 1 bis 3, dadurch gekennzeichnet,
daß der Verriegelungshebel (23) mittels eines Lagerbolzens (24) in einem taschenförmigen Teil des Schiebers (20) gelagert ist, das um mindestens die Dicke des Verriegelungshebels (23) von der Trägerschiene (10) abgesetzt ist.

5. Vorrichtung nach Anspruch 4, dadurch gekennzeichnet,
daß der Lagerbolzen (24) horizontal und senkrecht zur Längsachse der Trägerschiene (10) und des Auslegers (30) ausgerichtet ist und
daß eine als Zugfeder ausgebildete V- bzw. U-förmige Drahtfeder (27) den Verriegelungshebel (23) gegen die Trägerschiene (10) zieht, wobei ein Ende (28) der Drahtfeder (27) im Bereich der Oberkante des Schiebers (20) und das andere Ende (29) der Drahtfeder (27) an dem Ansatz (26) des Schiebers (20) eingehängt sind.

6. Vorrichtung nach einem der Ansprüche 1 bis 5, dadurch gekennzeichnet,
daß der Schieber (20) in einer U-förmigen Trägerschiene (10) mit hinterschnittenen Seitenschenkeln (11,12) verstellbar geführt ist.

7. Vorrichtung nach einem der Ansprüche 1 bis 5, dadurch gekennzeichnet,
daß der Schieber (20) auf einer U-förmigen Kugelführung (17) verstellbar geführt ist, die selbst mit ihren mit Kugelkäfigen (18) und Kugeln (19) versehenen Seitenschenkeln in der U-förmigen, mit hinterschnittenen Seitenschenkeln (11,12) versehenen Trägerschiene (10) verstellbar geführt ist.

## Claims

1. An assembly for laterally guiding a carrier for components which ca be inserted into a frame or a switch cabinet, the assembly comprising a carrier rail which can be horizontally connected to the frame or the switch cabinet, a slider which is axially slidable on the carrier rail or on a ball guide means which is displaceable in the carrier rail, and an arm which can be fixed to the slider and which can be connected to a side portion of the component carrier and which projects at the rear side thereof, wherein the arm in an inclined position relative to the carrier rail can be inserted into the slider and can be axially non-slidably fixed thereto by downward movement into the horizontal connecting position, characterised in that mounted on the slider (20) is a locking element which is loaded by means of a spring (27) and which, when the arm (30) is inclined or removed from the slider (20), engages by means of a locking projection (25) by virtue of the spring force into a locking receiving means (16) of the carrier rail (10) and axially non-slidably secures the slider (20) to the carrier rail (10), and that the arm (30) which is mounted on the slider (20) and which has been moved into the horizontal connecting position displaces the locking element against the spring force in such a way that the locking projection (25) moves out of the locking receiving means (16) and the slider (20) with the arm (30) secured thereto are axially displaceable on the carrier rail (10).

2. An assembly according to claim 1 characterised in that the locking element is in the form of a locking lever (23) which is rotatably mounted on the slider (20) and which is held in the direction of the locking position by means of the spring (27).

3. An assembly according to claim 2 characterised in that the slider (20) is provided with a horizontally directed engagement bar portion (21) at a position remote from the insertion side and with a vertical, upwardly open engagement bar portion (22) at a position towards the insertion side, that at its free end the arm (30) is provided with a horizontally directed insertion slot (31) and, at a position towards the component carrier, with a vertical, upwardly open introduction slot (32), that the locking lever (23) is mounted in the region of the lower edge of the slider (20) in such a way that it lies outside the carrier rail (10) and engages from the underside of the carrier rail (10) into the locking receiving means (16) provided in the lower side limb portion (11) of the carrier rail, and that the locking lever (23) is provided with a laterally projecting projection (26) on which the lower edge of the inserted arm (30) bears with resulting deflection of the locking lever.

4. An assembly according to one of claims 1 to 3 characterised in that the locking lever (23) is mounted by means of a mounting pin (24) in a pocket-shaped portion of the slider (20), which is set away from the carrier rail (10) by at least the thickness of the locking lever (23).

5. An assembly according to claim 4 charaterised in that the mounting pin (24) is directed horizontally and perpendicularly to the longitudinal axis of the carrier rail (10) and the arm (30), and that a V-shaped or U-shaped wire spring (27) which is in the form of a tension spring pulls the locking lever (23) towards the carrier rail (10), wherein one end (28) of the wire spring (27) is engaged in the region of the upper edge of the slider (20) and the other end (29) of the wire spring (27) is engaged to the projection (26) of the slider (20).

6. An assembly according to one of claims 1 to 5 characterised in that the slider (20) is displaceably guided in a U-shaped carrier rail (10) with side limb portions (11, 12) of undercut configuration.

7. An assembly according to one of claims 1 to 5 characterised in that the slider (20) is displaceably guided on a U-shaped ball guide means (17) which is itself guided with its side limb portions which are provided with ball cages (18) and balls (19), in the U-shaped carrier rail (10) which is provided with side limb portions (11, 12) of undercut configuration.

## Revendications

1. Dispositif destiné au guidage latéral d'un support de composants pouvant être introduit dans un bâti ou dans une armoire de commande de commutation, ce dispositif étant constitué par un rail-support pouvant être relié horizontalement au bâti ou à l'armoire de commande, par un curseur mobile axialement sur le rail-support ou sur un guidage à billes, lui-même mobile sur le rail-support, et par un bras pouvant être fixé sur le curseur, reliable à une partie latérale du support de composants et avançant sur la face arrière de celui-ci, lequel bras peut être introduit dans le curseur en position oblique par rapport au rail-support et peut être fixé sur celui-ci, en étant abaissé en position horizontale de raccordement, sans possibilité de déplacement axial, dispositif caractérisé en ce qu'un élément de verrouillage, chargé par un ressort (27) est monté sur le curseur (20); en ce que le bras (30) étant placé obliquement ou étant retiré du curseur (20) est, sous l'action du ressort, en prise par un appendice (25) de verrouillage avec une échancrure (16) de verrouillage du rail-support (10), et maintient le curseur (20) sur le rail-support (10) sans possibilité de déplacement axial; et en ce que le bras (30), fixé sur le curseur (20) et placé en position horizontale d'assemblage, déplace l'élément de verrouillage en surmontant l'action du ressort, de telle sorte que l'appendice (25) de verrouillage est délogé de l'échancrure (16) de verrouillage, et en ce que le curseur (20) peut être, avec le bras (30), fixé sur lui déplacé axialement sur le rail-support (10).

2. Dispositif selon la revendication 1, caractérisé en ce que l'élément de verrouillage est constitué par un levier (23) de verrouillage, qui est monté libre en rotation sur le curseur (20) et est maintenu par le ressort (27) en direction de la position de verrouillage.

3. Dispositif selon la revendication 2, caractérisé en ce que le curseur (20) est pourvu, à l'opposé du côté d'introduction, d'une attache (21) de fixation dirigée horizontalement et en regard du côté d'introduction, d'une attache (22) de fixation verticale, ouverte vers le haut, en ce que le bras (30) est pourvu, à son extrémité libre, d'une échancrure (31) d'encastrement dirigée horizontalement, et en regard du support de composants, d'une échancrure (32) verticale d'introduction, ouverte vers le bas, en ce que le levier (23) de verrouillage est monté dans la région de l'arête intérieure du curseur (20) de manière à se situer en-dehors du rail-support (10) et à s'encliqueter d'en bas sur la face intérieure du rail-support (10) dans l'échancrure (16) de verrouillage aménagée dans le montant latéral inférieur (11) de celui-ci et en ce que le levier (23) de verrouillage est pourvu d'un appendice (26), faisant saillie latéralement et sur lequel l'arête inférieure du bras (30) introduit s'appuie en déplaçant en conséquence le levier de verrouillage.

4. Dispositif selon l'une des revendications 1 à 3, caractérisé en ce que le levier (23) de verrouillage est monté au moyen d'une cheville (24) d'appui dans une partie en forme de poche du curseur (20), qui est décalée, par rapport au rail-support (10), d'au moins l'épaisseur du levier (23) de verrouillage.

5. Dispositif selon la revendication 4, caractérisé en ce que la cheville (24) d'appui est alignée horizontalement et verticalement par rapport à l'axe longitudinal du rail porteur (10) et du bras (30), et en ce qu'un ressort (27), en fil métallique en forme de V ou d'U, constituant un ressort de traction, tire le levier (23) de verrouillage vers le rail-support (10), une extrémité (28) du ressort (27) étant accrochée dans la région de l'arête supérieure du curseur (20) et l'autre extrémité (29) du ressort (27) étant accrochée à l'appendice (26) du curseur.

6. Dispositif selon l'une des revendications 1 à 5, caractérisé en ce que le curseur (20) est guidé avec possibilité de déplacement dans un rail-support (10) en forme d'U, pourvu de montants latéraux (11, 12) détalonnés.

7. Dispositif selon l'une des revendications 1 à 5, caractérisé en ce que le curseur (20) est guidé avec possibilité de déplacement sur un guidage (17) à billes en forme d'U, qui est lui-même guidé par ses montants latéraux, pourvus de cages (18) à billes et de billes (19), sur le rail-support (10) en forme d'U, pourvu de montants latéraux (11, 12) détalonnés.

EP 0 192 990 B1

FIG.1

FIG.2

FIG.3